# FASCICULE DE BREVET EUROPEEN

(11) **EP 0 725 766 B1**
(45) Date de publication et mention de la délivrance du brevet: **04.03.1998**
(21) Numéro de dépôt: 94926981.5
(22) Date de dépôt: 14.09.1994
(51) Int. Cl.: C04B 35/83, C04B 35/80

(54) **PROCEDE D'INFILTRATION CHIMIQUE EN PHASE VAPEUR D'UNE MATRICE PYROCARBONE AU SEIN D'UN SUBSTRAT POREUX AVEC ETABLISSEMENT D'UN GRADIENT DE TEMPERATURE DANS LE SUBSTRAT**
VERFAHREN ZUR CHEMISCHEN DAMFPHASENINFILTRATION EINER PYROKOHLENSTOFFMATRIX INS INNERE EINES PORÖSEN SUBSTRATES MIT EINSTELLUNG EINES TEMPERATURGRADIENTEN IM SUBSTRAT
CHEMICAL VAPOUR INFILTRATION PROCESS OF A PYROCARBON MATRIX WITHIN A POROUS SUBSTRATE WITH CREATION OF A TEMPERATURE GRADIENT IN THE SUBSTRATE

(30) Priorité: 27.10.1993 FR 9312806
(43) Date de publication de la demande: 14.08.1996
(73) Titulaire: SOCIETE EUROPEENNE DE PROPULSION, 92150 Suresnes (FR)
(72) Inventeur: DELPERIER, Bernard, F-33127 MARTIGNAS SUR JALLES (FR); DOMBLIDES, Jean-Luc, F-33520 Bruges (FR)
(74) Mandataire: Joly, Jean-Jacques
(86) Numéro de dépôt international: FR9401074
(87) Numéro de publication internationale: WO9511867

(56) Documents cités:
- FR-A- 2 225 396
- 16TH NATIONAL SAMPE SYMPOSIUM, 21 Avril 1971, ANAHEIM, US pages 257 - 265 W.V. KOTLENSKY 'A review of CVD carbon infiltration of porous substrates' cité dans la demande

## Description

La présente invention concerne un procédé d'infiltration chimique en phase vapeur d'une matrice de pyrocarbone au sein d'un substrat poreux.

Le domaine d'application de l'invention est plus particulièrement celui de la fabrication de pièces en matériau composite à renfort fibreux et matrice carbone. Les fibres sont des fibres en carbone ou en graphite, ou des fibres en un matériau réfractaire, par exemple céramique, éventuellement revêtues de carbone ou graphite.

L'infiltration chimique en phase vapeur est employée pour former un dépôt de pyrocarbone sur les fibres du substrat, dans tout le volume de celui-ci, afin de lier les fibres entre elles et combler la porosité initiale du substrat.

Pour réaliser l'infiltration chimique en phase vapeur, le substrat fibreux est placé dans une enceinte. Une phase gazeuse précurseur du carbone est admise dans l'enceinte. Dans des conditions de température et pression déterminées, la phase gazeuse diffuse au sein du substrat et forme le dépôt de pyrocarbone sur les fibres. La phase gazeuse est par exemple constituée d'un hydrocarbure ou d'un mélange d'hydrocarbures donnant du pyrocarbone par décomposition au contact des fibres du substrat.

Il existe plusieurs types de procédés d'infiltration chimique en phase vapeur : le procédé isotherme-isobare, le procédé à gradient de pression et le procédé à gradient de température.

Dans le procédé isotherme-isobare, le substrat à densifier est placé dans une enceinte isotherme. Le chauffage est assuré par exemple par un suscepteur, ou induit, en graphite qui entoure l'enceinte et est lui-même entouré par un bobinage inducteur. L'apport énergétique au substrat s'effectue essentiellement par rayonnement de l'enceinte sur le substrat. La température à l'intérieur de l'enceinte est régulée à la valeur voulue par commande du courant dans l'inducteur, tandis que la pression est réglée par liaison de l'enceinte avec une source de vide et commande du débit de la phase gazeuse admise dans l'enceinte. Le dépôt du matériau de la matrice s'effectue à l'intérieur du substrat et à la surface de celui-ci. La température et la pression sont choisies à des valeurs seulement légèrement supérieures à celles requises pour la formation du dépôt, afin d'éviter un dépôt massif en surface du substrat, dès le contact avec la phase gazeuse, qui conduirait à l'obturation rapide de la porosité de surface empêchant la densification au sein du substrat.

Toutefois, la fermeture progressive de la porosité de surface est inévitable et bloque le processus de densification avant que celle-ci soit complète au coeur du substrat. Il est alors nécessaire de procéder à un écroûtage de la surface par usinage afin de ré-ouvrir le réseau de porosités et poursuivre la densification. Plusieurs opérations intermédiaires d'écroûtage peuvent être nécessaires sur une même pièce avant d'arriver au niveau de densification souhaité.

Ce procédé, par le contrôle précis des conditions d'infiltration, permet d'obtenir une matrice de la qualité souhaitée, et ce de façon reproductible. Il présente aussi l'avantage important de permettre la densification simultanée de plusieurs pièces de formes diverses dans la même enceinte.

Face à ces avantages, qui justifient son utilisation à l'échelle industrielle, le procédé isotherme-isobare présente les inconvénients d'une durée élevée et d'un coût important, notamment pour la fabrication de pièces composites de forte épaisseur. En effet, la densification requiert des vitesses de dépôt faibles, donc des cycles de durée importante. De plus, les opérations intermédiaires d'usinage pour l'écroûtage provoquent des pertes de matière, qui contribuent à accroître le prix de revient, et l'alternance entre infiltration et écroûtage rallonge la durée totale de fabrication et son coût. Enfin, en particulier pour les pièces de forte épaisseur, un gradient de densification important subsiste inévitablement au sein d'une même pièce, le degré de densification étant sensiblement moins important au coeur de la pièce qu'à sa surface.

Le procédé à gradient de pression utilise un flux forcé de la phase gazeuse à travers la préforme. Cet écoulement forcé se traduit par une différence de pression à travers la pièce.

Outre qu'il nécessite une adaptation particulière du système de transport de la phase gazeuse, le procédé à gradient de pression présente une même limitation que le procédé isotherme-isobare. En effet, la perméabilité des pores à la phase gazeuse décroît rapidement avec formation d'un dépôt plus important du côté de la face d'entrée de la phase gazeuse. Un écroûtage périodique de cette face est nécessaire pour poursuivre la densification.

De plus, ce procédé n'est applicable que pour des configurations de substrat particulièrement simples et limitées et chaque pièce nécessite un dispositif particulier d'alimentation et de circulation de la phase gazeuse.

Le procédé à gradient de température consiste à réaliser un chauffage non uniforme du substrat, de sorte que celui-ci présente, au voisinage de sa surface exposée, une température moins élevée que dans des parties internes éloignées de cette surface. La réaction de dépôt étant thermiquement activée, la vitesse de dépôt, ou croissance de la matrice, augmente avec la température. Il s'ensuit une densification plus importante dans les parties les plus chaudes, au sein du substrat, que dans les parties les moins chaudes, au niveau de la surface exposée du substrat. On évite ainsi la formation d'un dépôt plus important en surface, avec obturation prématurée de la porosité, et la nécessité d'opérations intermédiaires. C'est à ce type de procédé d'infiltration que se rapporte la présente invention.

Un dispositif d'infiltration chimique en phase vapeur avec gradient de température a été présenté et décrit par W. V. Kotlensky au "16th National SAMPE Symposium, Anaheim, California, April 21-23, 1971" sous le titre "A. Review of CVD Carbon Infiltration of Porous Substrates" et dans un ouvrage intitulé "Chemistry and Physic of Carbon", édité aux Etats-Unis d'Amérique par P. L. Walker, vol. 9, p. 198-199.

Le substrat à densifier est appliqué par une face interne contre un induit en graphite. Le substrat et l'induit sont logés à l'intérieur d'une enceinte. Une bobine inductrice entoure l'enceinte. La phase gazeuse est admise à la base de l'enceinte et circule de bas en haut.

L'induit est chauffé par couplage électromagnétique avec l'inducteur et chauffe à son tour le substrat avec lequel il est en contact. Un gradient thermique s'établit à travers le substrat entre la face interne au contact de l'induit et la face externe exposée où s'établit une température plus faible en raison des pertes thermiques par radiation et des pertes par convection dues à la circulation de la phase gazeuse.

Le gradient thermique est plus ou moins important en fonction de la conductivité thermique du substrat.

Une autre technique d'infiltration chimique en phase vapeur avec gradient de température a été décrite par J. J. Gebhardt et al. dans un article intitulé "Formation of carbon-carbon composite materials by pyrolytic infiltration", Petroleum derived carbons ACS Series N° 21 6/73.

Dans ce cas, le substrat à densifier est constitué par des faisceaux de fibres de graphite entrelacés orientés dans 7 directions différentes. Le substrat est suspendu à l'intérieur d'une enceinte à la base de laquelle la phase gazeuse est admise. Les fibres de graphite sont suffisamment conductrices de l'électricité pour permettre le chauffage du substrat par couplage direct avec une bobine inductrice qui entoure l'enceinte.

La zone la plus chaude du substrat est située à l'intérieur de celui-ci, la surface extérieure étant refroidie par radiation et par la circulation de la phase gazeuse de bas en haut dans l'enceinte. Un gradient de température de quelques °C par centimètre est obtenu à partir de la partie interne la plus chaude.

Afin de maintenir un gradient de température suffisant, la phase gazeuse circule à vitesse élevée pour refroidir la surface et la bobine inductrice est limitée à quelques spires pour chauffer une zone limitée du substrat, de sorte qu'un gradient thermique s'établit aussi entre la partie du substrat située dans le champ de l'inducteur et la partie du substrat située hors du champ. La densification de tout le substrat est obtenue en le déplaçant dans l'enceinte, parallèlement à l'axe de la bobine. Ces contraintes font que le procédé ne peut être que d'un usage limité, difficilement industrialisable.

La présente invention a pour but de fournir un procédé d'infiltration chimique en phase vapeur de pyrocarbone au sein d'un substrat poreux dans lequel un gradient thermique a été établi. L'invention a notamment pour but d'améliorer encore l'effet du gradient thermique par lequel le dépôt de pyrocarbone est favorisé dans des parties internes du substrat éloignées des surfaces exposées de celui-ci.

Ce but est atteint grâce à un procédé selon lequel, conformément à l'invention, la phase gazeuse comprend un mélange constitué d'au moins un hydrocarbure saturé ou insaturé et d'hydrogène, et le substrat est chauffé de sorte qu'il s'établisse en son sein un gradient de température de part et d'autre d'une température de 1500° K.

Le procédé selon l'invention fait avantageusement application de la propriété de l'hydrogène d'agir sur la cinétique du dépôt (ou infiltration) chimique en phase vapeur de pyrocarbone avec un effet qui évolue du caractère inhibiteur au caractère catalytique par simple élévation de température.

En effet, dans le cas d'un dépôt de pyrocarbone sur une surface carbone ou graphite, il apparaît que l'hydrogène bloque les sites actifs de carbone par chimique-sorption et retarde la nucléation du pyrocarbone à une température d'environ 1300° K.

A des températures de 1300° K à 1400° K, l'hydrogène se chimie-sorbe, et inhibe la formation d'espèces réactionnelles dans la phase gazeuse.

A température plus élevée, environ de 1500° K à 1700° K, l'hydrogène active la surface carbone ou graphite et la vitesse de dépôt sur cette surface activée est plus élevée que sur une surface non activée.

Le gradient thermique est établi de sorte que les parties internes du substrat les plus chaudes sont à une température supérieure à 1500° K et les parties externes exposées à une température inférieure à 1500° K ; il y a alors synergie entre l'activation thermique du dépôt du pyrocarbone et l'effet catalytique ou inhibiteur de l'hydrogène pour favoriser le dépôt dans les parties internes du substrat, au détriment des parties adjacentes aux surfaces exposées. Il en résulte une diminution du risque d'obturation prématurée de la porosité de surface et une diminution du gradient de densification au sein du produit.

De préférence, dans le mélange d'au moins un hydrocarbure saturé ou insaturé et d'hydrogène, le pourcentage en volume d'hydrogène est compris entre 10 % et 50 %. L'hydrocarbure saturé ou insaturé est choisi notamment parmi les alcanes, tels que le méthane et le propane, les alcènes, les alcynes, les alkyles ou un mélange de plusieurs de ceux-ci.

L'invention sera mieux comprise à la lecture de la description faite ci-après, à titre indicatif mais non limitatif. On se référera aux dessins annexés sur lesquels :
- la figure 1 est une vue très schématique d'une installation permettant la mise en oeuvre du procédé selon l'invention,
- les figures 2 à 4 montrent la répartition de la température et de la vitesse de dépôt de pyrocarbone dans l'épaisseur du substrat dans différentes conditions, et
- la figure 5 illustre un autre mode de mise en oeuvre du procédé selon l'invention.

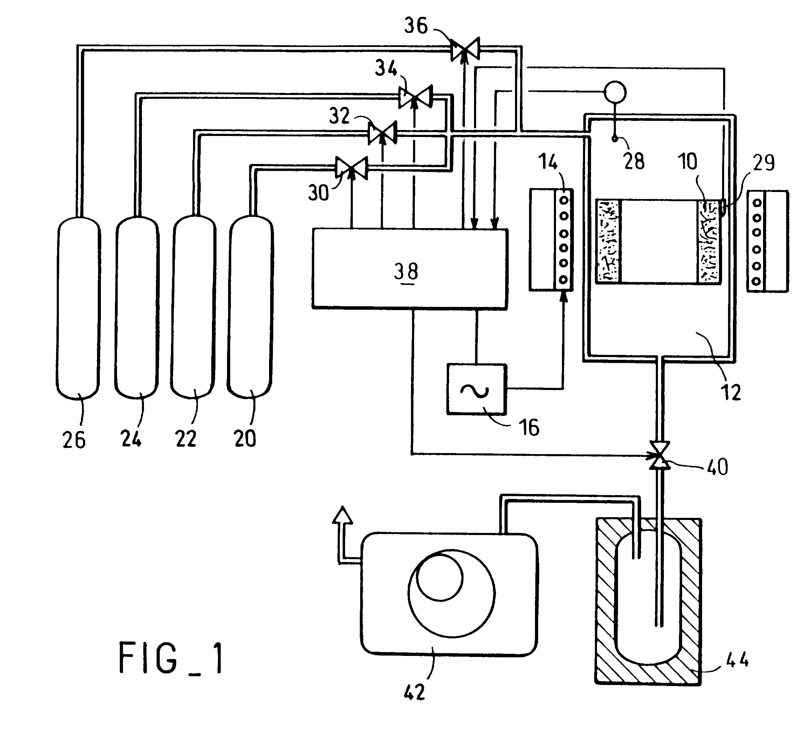

La figure 1 illustre très schématiquement une installation permettant l'infiltration chimique en phase vapeur de pyrocarbone au sein d'un substrat poreux chauffé par couplage direct avec un inducteur.

Le substrat 10 est disposé à l'intérieur d'une enceinte 12. Dans cet exemple, le substrat 10 est une structure fibreuse de forme cylindrique annulaire à section méridienne rectangulaire. Le chauffage du substrat et assuré par couplage électromagnétique direct avec une bobine inductrice 14 qui entoure l'enceinte. Le substrat 10 et la bobine 14 sont coaxiaux.

La bobine 14 s'étend axialement sur une longueur égale ou supérieure à celle du substrat 10 de sorte que celui-ci se trouve entièrement à l'intérieur du champ électromagnétique engendré par la bobine 14.

La phase gazeuse propre à former le dépôt de pyrocarbone sur les fibres du substrat 10 est admise à la partie supérieure de l'enceinte 12. La phase gazeuse comprend un mélange d'au moins un alcane, alcène, alcyne ou alkyle et d'hydrogène, par exemple un mélange de méthane, de propane et d'hydrogène. Le méthane, le propane et l'hydrogène sont fournis par des sources de gaz respectives 20, 22, 24 à travers des vannes d'injection respectives 30, 32, 34.

Lors du processus d'infiltration chimique en phase vapeur, les produits de réaction gazeux, y compris le reliquat de phase gazeuse réactionnelle, sont extraits à la partie inférieure de l'enceinte 12. L'extraction est réalisée par ouverture d'une vanne 40 qui met la chambre en communication avec une pompe à vide 42 à travers un piège à azote liquide 44 permettant de retenir les espèces gazeuses indésirables et d'éviter leur rejet dans le milieu ambiant. L'extraction des gaz de réaction par mise sous vide peut être remplacée ou complétée par un balayage de l'enceinte 12 par un gaz inerte, tel que l'azote ou l'argon, qui est introduit dans l'enceinte à partir d'une source 26 à travers une vanne d'injection 36.

Les vannes 30, 32, 34, 36 sont commandées par un automate 38. L'automate reçoit un signal produit par un capteur 28 et représentatif de la pression dans l'enceinte 12 et commande la vanne 36 pour que règne une pression déterminée dans l'enceinte avant l'admission de la phase gazeuse. L'automate commande en outre un générateur 16 produisant le courant d'alimentation de la bobine 14 pour chauffer le substrat dans les conditions voulues. Il reçoit à cet effet un signal produit par un capteur de température 29, par exemple un thermocouple, placé au contact d'une surface exposée du substrat.

Le substrat 10 est en fibres conductrices de l'électricité. Il présente des caractéristiques de résistivité électrique et de conductivité thermique qui le rendent apte à être chauffé par couplage direct avec la bobine 14.

Un type de structure convenant particulièrement pour le substrat 10 est une structure en fibres de carbone ou graphite aiguilletée.

Un procédé de réalisation d'une telle structure tridimensionnelle est décrit dans le document FR-A-2 584 107. Les caractéristiques souhaitables de résistivité électrique et conductivité thermique sont par exemple celles données dans la demande de brevet français déposée par la demanderesse le même jour que la présente demande sous le titre "Procédé d'infiltration chimique en phase vapeur d'un matériau au sein d'un substrat fibreux avec établissement d'un gradient de température dans celui-ci" à laquelle il est fait expressément référence. En résumé, la résistivité électrique radiale est comprise de préférence entre 1 et 20 mΩ/cm et le rapport entre résistivité électrique radiale et résistivité électrique circonférentielle est de préférence au moins égal à 1,3, tandis que la conductivité thermique radiale est comprise de préférence entre 0,1 et 20 W/m.° K et que le rapport entre conductivité thermique radiale et conductivité thermique circonférentielle est de préférence au plus égal à 0,9. Ces caractéristiques peuvent être atteintes avec un taux volumique de fibres, c'est-à-dire le pourcentage du volume apparent du substrat effectivement occupé par les fibres égal à au moins 20 %, de préférence au moins 25 %.

Le chauffage du substrat par induction est produit par effet Joule, par les courants induits. Il est bien connu que ceux-ci se concentrent en surface (effet de peau), et ce d'autant plus que la fréquence du courant alimentant l'inducteur est élevée.

En dépit de l'effet de peau, par le choix d'une fréquence convenable et en tenant compte du refroidissement en surface du substrat par radiation et convection (écoulement de la phase gazeuse), il est possible, d'obtenir un gradient de température au sein du substrat.

A l'évidence, la fréquence la mieux adaptée dépend de plusieurs paramètres : nature des fibres constituant le substrat, épaisseur de celui-ci, valeurs de résistivité électrique et conductivité thermique,...

A titre indicatif, pour un substrat aiguilleté en fibres de carbone obtenu comme décrit ci-dessus, la fréquence optimale se trouve dans la gamme d'environ 150 Hz à environ 3000 Hz, selon le taux de fibres et l'épaisseur du substrat.

Dans l'exemple illustré par la figure 1, le substrat 10 a une forme cylindrique à section droite circulaire. Le procédé selon l'invention peut être mis en oeuvre avec des substrats ayant d'autres formes, notamment des substrats cylindriques à section non circulaire ou des substrats axi-symétriques non cylindriques, en adaptant, le cas échéant, la forme de l'inducteur.

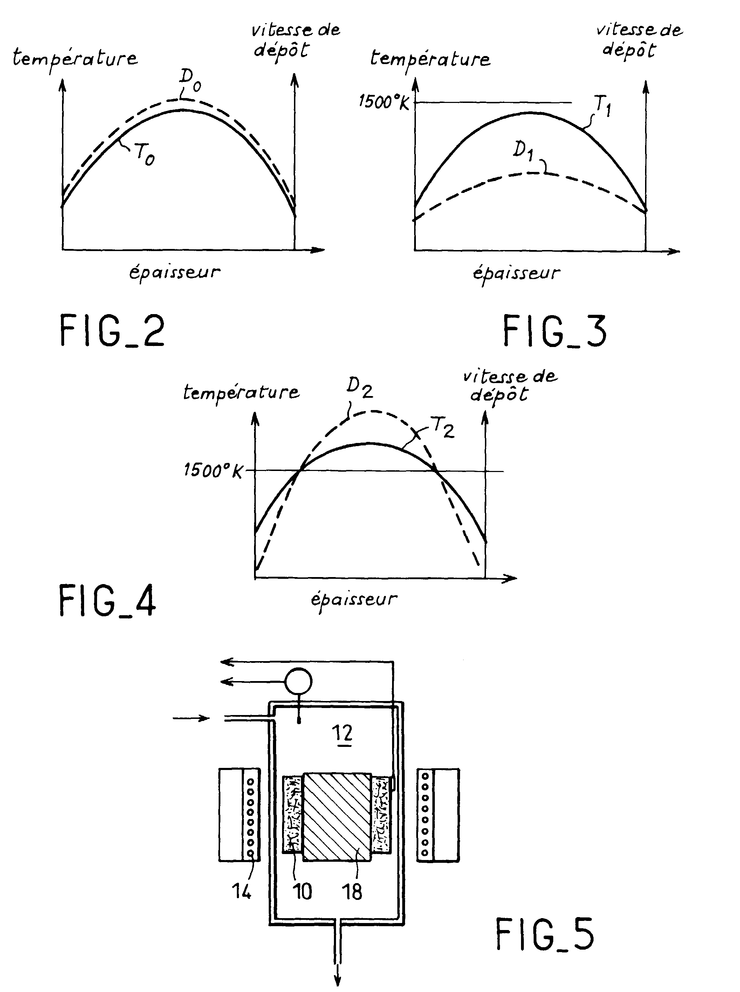

Lorsque l'inducteur 14 est alimenté, au début de l'infiltration chimique en phase vapeur, il s'établit dans le substrat, entre le diamètre intérieur et le diamètre extérieur, un profil de température tel qu'illustré par la courbe T₀ de la figure 2. Le maximum de température est ici supposé s'établir sensiblement au niveau du diamètre moyen du substrat. Il pourra se rapprocher du diamètre extérieur lorsque l'épaisseur du substrat est relativement grande.

La vitesse de dépôt du pyrocarbone est activée par la température du substrat. Dans l'hypothèse où la phase gazeuse ne comprend pas d'hydrogène, le profil de vitesse de dépôt au sein du substrat correspond au profil de température, comme indiqué par la courbe D₀ de la figure 2.

Comme indiqué plus haut, la présence d'hydrogène dans la phase gazeuse précurseur de pyrocarbone a un effet inhibiteur sur la vitesse de dépôt lorsque la température est inférieure à 1500° K, en particulier dans la plage 1300 à 1400° K où l'hydrogène se chimie-sorbe et inhibe la formation d'espèces réactionnelles dans la phase gazeuse.

Ainsi, lorsque la température des parties les plus chaudes du substrat est inférieure à 1500° K, le profil de répartition de vitesse de dépôt prend l'allure de la courbe D₁ de la figure 3, le profil de température (courbe T₁) ayant sensiblement la même allure que dans le cas de la figure 2. La vitesse de dépôt est nettement ralentie tout en conservant un maximum au niveau des parties les plus chaudes.

Par contre, lorsque le profil de température, tout en conservant une allure semblable aux profils de température précédent, recouvre une plage qui s'étend de part et d'autre de 1500° K (courbe T₂ de la figure 4), le profil de vitesse de dépôt prend l'allure de la courbe D₂ de la figure 4. Dans les parties du substrat où la température est supérieure à 1500° K, l'hydrogène active la surface carbone ou graphite des fibres, entraînant une élévation de la vitesse de dépôt en comparaison avec le profil D₀ de la figure 2 ; par contre, dans les parties du substrat où la température est inférieure à 1500° K, l'effet de la présence d'hydrogène est inverse, entraînant une diminution de la vitesse de dépôt. L'effet du gradient thermique est donc amplifié par l'apport d'hydrogène dans un sens favorable à un dépôt de pyrocarbone plus rapide au sein du substrat qu'au niveau de ses surfaces exposées. Une densification plus uniforme du substrat peut donc être réalisée.

Cette synergie entre le gradient thermique et la présence d'hydrogène se produit dès lors que la surface des fibres est en carbone ou graphite. En effet, l'inhibition du dépôt de pyrocarbone par l'hydrogène est due à un blocage des sites actifs de carbone par chimie-sorption qui retarde la nucléation du pyrocarbone, tandis que l'activation du dépôt de pyrocarbone est due à l'activation de la surface carbone des fibres.

Le chauffage du substrat est réalisé de manière à établir le gradient de température souhaité de part et d'autre de la valeur de 1500° K. A cet effet, compte-tenu de la nature du substrat, le courant dans l'inducteur 14 est commandé par l'automate 38 pour que la température à la surface exposée du substrat mesurée par le capteur 29 soit inférieure à 1500° K, sans être à un niveau trop bas, pour que les parties les plus chaudes du substrat soient à une température supérieure à 1500° K.

De préférence, il est fait en sorte que la température du substrat, dans ses parties les plus chaudes, est comprise entre 1500° K et 2000° K et, au niveau de ses surfaces exposées, est comprise entre 1000° K et 1300° K.

Le domaine d'application de l'invention est donc notamment celui de la densification des substrats fibreux en carbone ou graphite, ou revêtus de carbone ou graphite. Il n'est toutefois pas nécessaire que le substrat de départ soit en fibres de carbone ou graphite, ou en fibres revêtues préalablement de carbone ou graphite. En effet, dès lors que les fibres ont été revêtues de pyrocarbone au début du processus d'infiltration chimique en phase vapeur, l'effet inhibiteur ou catalytique de l'hydrogène peut se produire.

Le pourcentage d'hydrogène dans le mélange constitué par au moins un hydrocarbure gazeux saturé ou insaturé et l'hydrogène est de préférence compris entre 10 % et 50 %. Dans le cas où, comme dans l'exemple envisagé plus haut, la phase gazeuse est constituée de méthane, de propane et d'hydrogène, le pourcentage en volume de méthane est compris entre 50 % et 90 %, le pourcentage en volume de propane est compris entre 0 % et 50 % et le pourcentage en volume d'hydrogène est compris entre 10 % et 50 %.

D'autres alcanes ou des alcènes, alcynes ou alkyles pourront être utilisés en remplacement du méthane et du propane ou en complément de ceux-ci.

Une variante de mise en oeuvre du procédé selon l'invention est illustrée par la figure 5 qui est une vue partielle d'une installation d'infiltration chimique en phase vapeur. Les éléments communs aux modes de réalisation des figures 1 et 5 portent les mêmes références et ne seront pas à nouveau décrits.

Le mode de réalisation de la figure 5 se distingue de celui de la figure 1 par le fait que le chauffage du substrat 10 est réalisé non pas par couplage direct avec l'inducteur 14, mais par contact avec un induit massif en graphite 18 sur lequel le substrat annulaire 10 est engagé.

Le couplage électromagnétique se produit essentiellement entre l'inducteur 14 et l'induit 18. Un gradient de température s'établit en direction radiale dans le substrat 10 entre la surface interne la plus chaude au contact de l'induit 18 et la surface externe exposée la moins chaude.

L'effet du gradient thermique sur la vitesse de dépôt se combine avec l'effet de l'apport d'hydrogène de la même façon que décrit ci-avant, dès lors que la température dans le substrat décroît d'une valeur supérieure à 1500° K au niveau de la surface interne à une valeur inférieure à 1500° K au niveau de la surface externe.

Le mode de réalisation convient plus particulièrement pour des substrats présentant une résistivité électrique telle qu'un chauffage par couplage électromagnétique direct ne peut pas être envisagé.

## Revendications

1. Procédé de densification d'un substrat poreux par une matrice de pyrocarbone obtenue par infiltration chimique en phase vapeur, procédé comportant les étapes qui consistent à :
- placer le substrat dans une enceinte,
- chauffer le substrat de façon à permettre l'établissement d'un gradient de température au sein du substrat de sorte que celui-ci présente une température plus élevée dans des parties éloignées de ses surfaces exposées qu'au niveau de celles-ci, et
- admettre dans l'enceinte une phase gazeuse précurseur du carbone comprenant au moins un hydrocarbure saturé ou insaturé, la formation du pyrocarbone étant favorisée dans les parties du substrat de température plus élevée,
caractérisé en ce que
- la phase gazeuse comprend un mélange constitué d'au moins un hydrocarbure saturé ou insaturé et d'hydrogène, et
- le gradient thermique établi au sein du substrat est tel que les parties internes du substrat les plus chaudes sont à une température supérieure à 1500°K à laquelle le dépôt de pyrocarbone est favorisé par la présence d'hydrogène, et les parties externes exposées du substrat sont à une température inférieure à 1500°K à laquelle le dépôt de pyrocarbone est inhibé par la présence d'hydrogène.

2. Procédé selon la revendication 1, caractérisé en ce que le pourcentage en volume d'hydrogène, dans le mélange constitué d'au moins un hydrocarbure saturé ou insaturé et d'hydrogène, est compris entre 10 % et 50 %.

3. Procédé selon l'une quelconque des revendications 1 et 2, caractérisé en ce que la température du substrat, dans ses parties les plus chaudes, est comprise entre 1500° K et 2000° K.

4. Procédé selon l'une quelconque des revendications 1 à 3, caractérisé en ce que la température du substrat, au niveau de ses surfaces exposées, est comprise entre 1000° K et 1300° K.

5. Procédé selon l'une quelconque des revendications 1 à 4, caractérisé en ce que la phase gazeuse comprend un mélange constitué d'au moins un alcane choisi parmi le méthane et le propane, et d'hydrogène.

6. Procédé selon la revendication 5, caractérisé en ce que la phase gazeuse comprend un mélange constitué de méthane, de propane et d'hydrogène dans lequel le pourcentage en volume de méthane est compris entre 50 % et 90 %, le pourcentage de propane entre 0 % et 50 % et le pourcentage en volume d'hydrogène est compris entre 10 % et 50 %.

7. Procédé selon l'une quelconque des revendications 1 à 6, caractérisé en ce que le substrat est formé de fibres dont la surface au moins est en carbone ou graphite.

8. Procédé selon l'une quelconque des revendications 1 à 7, caractérisé en ce que le substrat est formé de fibres de carbone ou graphite.

## Patentansprüche

1. Verfahren zur Verdichtung eines porösen Substrats mit einer durch chemische Infiltration in der Dampfphase erhaltenen Pyrokohlenstoffmatrix, folgende Schritte aufweisend:
- Anordnen des Substrats in einem Behälter,
- Erwärmen des Substrats auf eine Art, die das Einstellen eines Temperaturgradienten im Inneren des Substrats dergestalt erlaubt, daß dieses eine höhere Temperatur zeigt in Bereichen, die entfernt sind von seinen exponierten Oberflächen, als an diesen Oberflächen, und
- Einlassen einer Gasphase eines Kohlenstoff-Vorläufers, die mindestens einen gesättigten oder ungesättigten Kohlenwasserstoff enthält, in den Behälter, wobei die Bildung des Pyrokohlenstoffs in den Bereichen des Substrats mit höherer Temperatur begünstigt wird,
dadurch gekennzeichnet, daß
- die Gasphase ein Gemisch enthält, das aus mindestens einem gesättigten oder ungesättigten Kohlenwasserstoff und Wasserstoff besteht, und
- der im Inneren des Substrats eingestellte Temperaturgradient so ist, daß sich die wärmsten inneren Bereiche des Substrats bei einer Temperatur oberhalb 1500°K, bei der die Abscheidung von Pyrokohlenstoff durch die Anwesenheit von Wasserstoff begünstigt wird, befinden und sich die exponierten Außenbereiche des Substrats bei einer Temperatur unterhalb 1500°K, bei der die Abscheidung von Pyrokohlenstoff durch die Anwesenheit von Wasserstoff gehemmt wird, befinden.

2. Verfahren nach Anspruch 1, dadurch gekennzeichnet, daß der Volumenprozentsatz des Wasserstoffs in dem Gemisch, das aus mindestens einem gesättigten oder ungesättigten Kohlenwasserstoff und Wasserstoff besteht, zwischen 10% und 50% liegt.

3. Verfahren nach Anspruch 1 oder 2, dadurch gekennzeichnet, daß die Temperatur des Substrats in seinen wärmsten Bereichen zwischen 1500°K und 2000°K liegt.

4. Verfahren nach einem der Ansprüche 1 bis 3, dadurch gekennzeichnet, daß die Temperatur des Substrats an seinen exponierten Oberflächen zwischen 1000°K und 1300°K liegt.

5. Verfahren nach einem der Ansprüche 1 bis 4, dadurch gekennzeichnet, daß die Gasphase ein Gemisch, das aus mindestens einem aus Methan und Propan ausgewählten Alkan und Wasserstoff besteht, enthält.

6. Verfahren nach Anspruch 5, dadurch gekennzeichnet, daß die Gasphase ein Gemisch enthält, das aus Methan, Propan und Wasserstoff besteht, wobei der Volumenprozentsatz des Methans zwischen 50 und 90% liegt, der Prozentsatz des Propans zwischen 0% und 50% liegt und der Volumenprozentsatz des Wasserstoffs zwischen 10% und 50% liegt.

7. Verfahren nach einem der Ansprüche 1 bis 6, dadurch gekennzeichnet, daß das Substrat aus Fasern gebildet ist, bei denen mindestens die Oberfläche aus Kohlenstoff oder Graphit ist.

8. Verfahren nach einem der Ansprüche 1 bis 7, dadurch gekennzeichnet, daß das Substrat aus Fasern aus Kohlenstoff oder Graphit gebildet ist.

## Claims

1. A method of densifying a porous substrate with a pyrolytic carbon matrix obtained by chemical vapor infiltration, the method comprising the following steps:
- placing the substrate in an enclosure;
- heating the substrate so as to enable a temperature gradient to be established within the substrate so that the substrate has a higher temperature in portions remote from its exposed surfaces than at said surfaces; and
- admitting into the enclosure a gaseous phase that constitutes a precursor of carbon, comprising at least one saturated or unsaturated hydrocarbon, with the formation of pyrolytic carbon being favored in the higher temperature portions of the substrate;
the method being characterized in that:
- the gaseous phase comprises a mixture made up of at least one saturated or unsaturated hydrocarbon together with hydrogen; and
- the thermal gradient established within the substrate is such that the hottest internal portions of the substrate are at a temperature which is higher than 1500°K, and at which deposition of pyrolytic carbon is favored by the presence of hydrogen, and the exposed external portions of the substrate are at a temperature which is lower than 1500°K, and at which deposition of pyrolytic carbon is inhibited by the presence of hydrogen.

2. A method according to claim 1, characterized in that the volume percentage of hydrogen in the mixture made up of at least one saturated or unsaturated hydrocarbon and hydrogen lies in the range 10% to 50%.

3. A method according to any one of claims 1 and 2, characterized it that the temperature of the substrate in the hottest portions thereof lies in the range 1500°K to 2000°K.

4. A method according to any one of claims 1 to 3, characterized in that the temperature of the substrate at its exposed surfaces lies in the range 1000°K to 1300°K.

5. A method according to any one of claims 1 to 4, characterized in that the gaseous phase comprises a mixture made up of at least one alkane selected from methane and propane, together with hydrogen.

6. A method according to claim 5, characterized in that the gaseous phase comprises a mixture made up of methane, propane, and hydrogen, in which the volume percentage of methane lies in the range 50% to 90%, the percentage of propane lies in the range 0% to 50%, and the volume percentage of hydrogen lies in the range 10% to 50%.

7. A method according to any one of claims 1 to 6, characterized in that the substrate is made of fibers with at least the surface thereof being made of carbon or graphite.

8. A method according to any one of claims 1 to 7, characterized in that the substrate is made of carbon or graphite fibers.
